# EUROPÄISCHE PATENTANMELDUNG

(11) **EP 1 137 182 A2**
(43) Veröffentlichungstag der Anmeldung: **26.09.2001**
(21) Anmeldenummer: 01104984.8
(22) Anmeldetag: 01.03.2001
(51) Int. Cl.: H03K 17/082, H03K 17/56

(54) **Halbleiterbauelement zur Ansteuerung von Leistungshalbleiterschaltern**

(30) Priorität: 22.03.2000 DE 10014269
(71) Anmelder: SEMIKRON Elektronik GmbH, 90431 Nürnberg (DE)
(72) Erfinder: Herzer, Reinhard, Dr., 98693 Ilmenau (DE); Masannek, Jürgen, 90461 Nümberg (DE); Lehmann, Jan, 98693 Ilmenau (DE); Pawel, Sascha, 98693 Ilmenau (DE)

(57) **Zusammenfassung**

Es wird ein Halbleiterbauelement mit Schnittstellenfunktionen zwischen dem Kontroller und den Leistungsbauelementen von Leistungsumrichtern, geeignet zum Ansteuern von Halbleiterbauelementen beschrieben. Das Halbleiterbauelement dient insbesondere zur Ansteuerung von IGBT- und MOSFET- Leistungsschaltern in Drei-Phasen-Brückenschaltungen kleiner und mittlerer Leistung und integriert die Signalaufbereitung (12), Pegelwandlung (16) und Verstärkung (Gatetreiber) (17), Fehlererfassung, wie Kurzschlussüberwachung mittels VCE-Detektion (19) und Betriebsspannungsüberwachung (21) sowie eine Fehlerverarbeitung (15) für mehrere Leistungshalbleiterschalter.

Die Vorteile dieses Ansteuer-IC gegenüber hybriden oder diskreten Lösungen bestehen in der hohen Integrationsdichte verschiedener Digital-, Analog- und Treiberfunktionen, die zu einer Reduzierung der Anzahl der diskreten Bauelemente und damit zu einer Verringerung der Ausfallrate des Systems und niedrigeren Kosten führen. Ein weiterer wesentlicher Gesichtspunkt ist die Verbesserung der Schaltungseigenschaften durch die monolithische Integration. Die integrierte Schaltung besitzt eine geringere Störspannungsempfindlichkeit sowie eine geringere Temperaturdrift im Vergleich zu diskret aufgebauten Schaltungen.

## Beschreibung

Die Erfindung beschreibt ein Halbleiterbauelement mit Schnittstellenfunktionen zwischen dem Kontroller und den Leistungsbauelementen von Leistungsumrichtern, geeignet zum Ansteuern von Halbleiterbauelementen, insbesondere zur Ansteuerung von IGBT- und MOSFET- Leistungsschaltern nach den Merkmalen des Oberbegriffes des Anspruches 1.

Hybride Ansteuerschaltungen sind aus dem Stand der Technik bekannt. Im "Applikationsbuch IGBT- und MOSFET- Leistungsmodule" (ISBN 3-932633-24-5) sowie im Katalog '99 der SEMIKRON Elektronik GmbH werden derartige Schaltungsanordnungen zur Ansteuerung von Halbleiterleistungsschaltern beschrieben. Zur Erläuterung der Ansteuerproblematik werden nachfolgend Blockschaltbilder herangezogen.

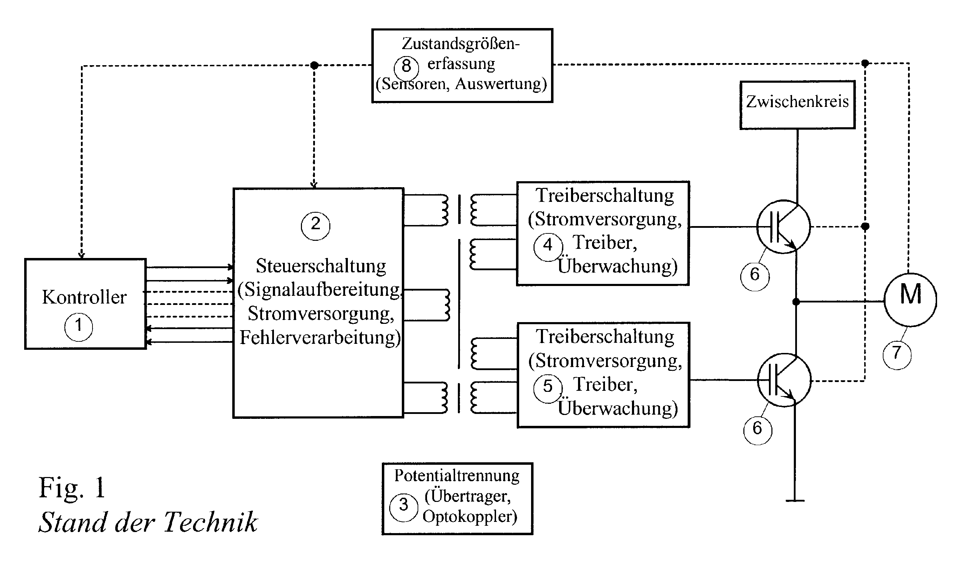

**Fig. 1** stellt den prinzipiellen Aufbau eines leistungselektronischen Systems zur Ansteuerung von Hochspannungs-IGBTs (Insulated Gate Bipolar Transistoren) nach dem Stand der Technik dar.

Das leistungselektronische System besteht im einzelnen aus:
- einem Kontroller (1) mit z.B. Mikroprozessor, Speicher und A/D- bzw. D/A-Wandlereinheit,
- einer Steuerschaltung (2) mit Digital-, Analog- und Leistungskomponenten zur Signalaufbereitung sowie Stromversorgung und Fehlerverarbeitung,
- einer Potentialtrennung (3) zwischen Nieder- und Hochspannungsseite,
- der Treiberschaltung (4) mit Stromversorgung, Gatetreiber und Überwachung,
- dem Spannungszwischenkreis (5),
- den Leistungsschaltern (6),
- einem Verbraucher (7) und
- Sensoren mit Auswerteschaltungen (8).

Zur Darstellung der Verbindung zu den Leistungshalbleiterschaltern sind ausschnittsweise aus einer Umrichterschaltung zwei IGBTs einer Halbbrücke, der Spannungszwischenkreis des Umrichters und der Verbraucher (hier symbolisiert durch einen Motor) gezeichnet.

Sensoren für alle relevanten Betriebsdaten mit möglichen Auswerteschaltungen, mit denen Zustandsgrößen des Verbrauchers und der Leistungsschalter (z.B. Drehzahl, Lage, Drehmoment bzw. Temperatur, Spannung, Strom und Kurzschluss) erfaßt werden und an die Steuerschaltung oder den Kontroller weitergeleitet werden, liefern die kompatiblen Daten für die Zustandsgrößenerfassung des in Betrieb befindlichen Umrichters.

Für Niederspannungsanwendungen (z.B. Batterieanwendungen, Automobilanwendungen mit Zwischenkreisspannungen kleiner 100V) existieren heutzutage Halbleitertechnologien, die eine weitgehende monolithische Integration von Kontroller, Steuer- und Treiberschaltung sowie Potentialtrennung und Zustandsgrößenerfassung möglich machen. Bei höheren Zwischenkreisspannungen wird die Integration der Potentialtrennung (bzw. Pegelwandlerstufe) wegen der Isolationsprobleme immer schwieriger. Lösungen für die Integration von Pegelwandlerstufen bis 600V und neuerdings auch bis 1200V gehören zum Stand der Technik, sie sind bei International Rectifer (Data Sheet IR2130, IR2235) beschrieben. Die Vorteile dieser Lösungen liegen in dem hohe Integrationsgrad und den dadurch bedingten niedrigen Kosten. Nachteilig sind der eingeschränkte Spannungsbereich und die begrenzte Treiberleistung, die mit zunehmender Spannungsfestigkeit abnimmt.

Die begrenzten Einsatzmöglichkeiten, die mit der erforderlichen Bootstrap-Stromversorgung zusammenhängen, und die nicht vorhandene echte galvanische Trennung sind beim Stand der Technik sehr nachteilig. Für mittlere und hohe Leistungen sind deshalb auch hier zusätzliche Optokoppler oder Übertrager und Nachverstärker notwendig.

Eine monolithische integrierte Potentialtrennung ist nur durch dielektrische Isolationstechnologien, wie z.B. Hilfsträgertechnologie, wie sie von C.Y. Lu (IEEE Trans. On E.D., ED 35 (1998), S.230-239) beschrieben wird, Waferbonden mit Trenchisolation nach K.G. Oppermann & M. Stoisiek (ISPSD 1996, Proc. S.239-242) bzw. durch die SIMOX-Technologie nach Vogt et al. (ISPSD 1997, Proc. S.317-320) möglich. Diese Technologien sind wegen der realisierbaren Oxiddicken von kleiner 2µm auf Isolationsspannungen kleiner als 1200V (meist 600V) begrenzt und außerdem sehr kostenintensiv.

In der Praxis werden für Spannungen größer als 100V diskrete Optokoppler oder Übertrager zur Potentialtrennung zwischen Nieder- und Hochspannungsseite verwendet. Der Vorteil von Übertragern gegenüber Optokopplern ist der bidirektionale Datenfluß für Steuersignale. Außerdem ist nur mit ihnen eine potentialfreie Leistungsübertragung für die Stromversorgung der Hochspannungsseite möglich. Nachteilig ist, dass Übertrager eine deutlich höhere Ansteuerleistung für die Signalübertragung benötigen.

Werden diskrete Optokoppler oder Übertrager verwendet, so sind separate, diskrete oder integrierte Schaltungen sowohl auf der Nieder- als auch auf der Hochspannungsseite notwendig. In bestimmten Fällen (z.B. kleinen Leistungen, wenige Analogfunktionen) ist eine monolithische Integration der Funktionen der Niederspannungsseite mit dem Kontroller möglich.

Eine andere Möglichkeit nach dem Stand der Technik ist die hybride Integration von Optokopplerbausteinen mit integriertem Schaltkreis mit Treiber- und Überwachungsfunktionen (auf der Hochspannungsseite) in einem speziellen Gehäuse (Hewlett Packard Data Sheet HCPL-316/, 12/97). Hierbei wird eine hohe Funktionsintegration für hohe Spannungen (von 600V bis 1200V) sowie mittlere und hohe Leistungen realisiert.

Lediglich die Hochspannungsdiode zur Überwachung der Spannung zwischen Kollektor und Emitter (VCE) wegen eines möglichen Kurzschlusses am IGBT, die Stromversorgung für die Hochspannungsseite und einige schwer integrierbare passive Komponenten bzw. Bauelemente für optionale Funktionen müssen in der Treiberschaltung diskret pro Zweig ergänzt werden.

Bei hybriden IGBT- Ansteuerschaltkreisen mit galvanischer Trennung der Primärseite von der Sekundärseite mittels Optokopplern wird ein schneller Koppler für den Signalweg benutzt und ein meist langsamer zweiter für die Fehlerrückmeldung.

Für die VCE- und Versorgungsspannungsüberwachung auf der Hochspannungsseite (Sekundärseite) existieren bereits integrierte Bausteine (Motorola Data Sheet MC 33 153). Die sekundärseitige potentialfreie Spannungsversorgung wird wegen des höheren Leistungsbedarfes mit einem DC/DC-Wandler realisiert. Die Stabilisierung der Versorgungsspannung erfolgt üblicherweise über eine Längsreglerschaltung. Bei der Spannungsversorgung der Sekundärseite mit einem DC/DC-Wandler werden die drei BOTTOM-Schalter einer Drehstromhalbbrückenschaltung im allgemeinen zu einer Spannungsversorgung zusammengefaßt.

Die Funktionen der Niederspannungsseite (wie z.B. Signalaufbereitung, Fehlerverarbeitung, Stromversorgung) werden nach dem Stand der Technik durch diskrete Bauelemente realisiert oder insbesondere die digitalen Funktionen vom Kontroller übernommen.

In der DE 198 51 186 wird ein Schaltkreis vorgestellt, bei dem alle Funktionen der Primärseite zur Ansteuerung, Überwachung und Stromversorgung von Leistungsbauelementen (MOSFET oder IGBT) in einer Drei-Phasen-Brückenschaltung für einen mittleren Leistungsbereich realisiert wird. Diese integrierte Schaltung muß dabei sämtliche Schnittstellen-Funktionen zwischen dem Kontroller sowie den sechs Treibern und den IGBT-Schaltern der Hochspannungsseite erfüllen. Für die Potentialtrennung zur Sekundärseite (Hochspannungsseite) werden Optokoppler (für Ansteuersignale) nach dem Stand der Technik verwendet und für die sekundärseitigen Treiber- und Überwachungsfunktionen jeweils eine Schaltung pro Leistungsschalter eingesetzt.

Die vorliegende Erfindung hat die Aufgabe, ein monolithisch integriertes Halbleiterbaulement für eine direkte Gateansteuerung und Überwachung von mehreren Halbleiterschaltern innerhalb eines Umrichters vorzustellen.

Diese Aufgabe wird durch die Maßnahmen des kennzeichnenden Teiles des Anspruchs 1 gelöst, vorteilhafte Ausführungsvarianten sind in den nachgeordneten Ansprüchen aufgezeigt.

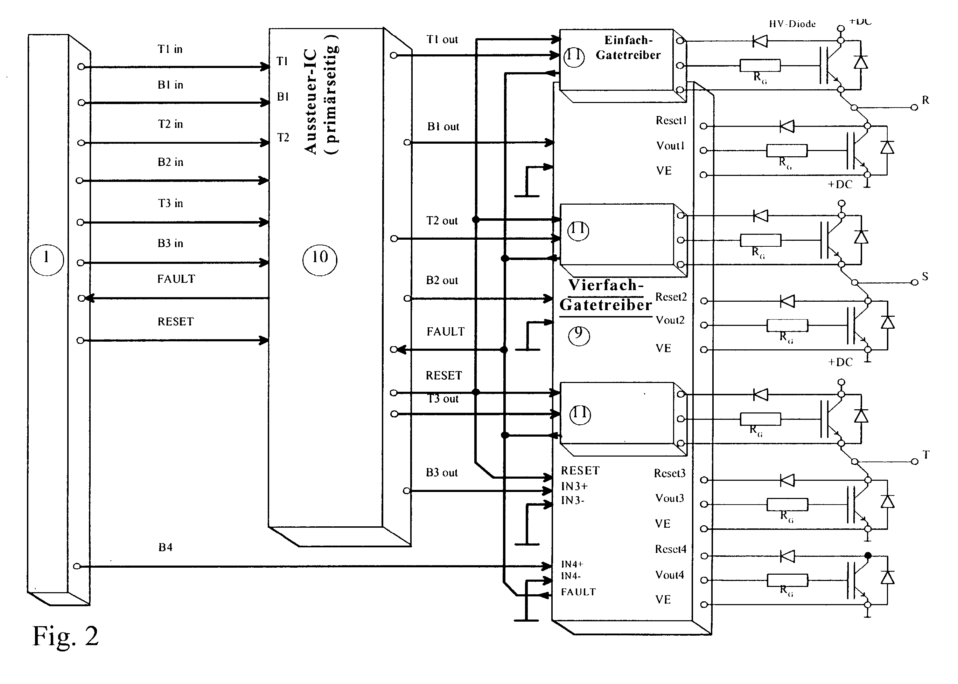

Am Beispiel einer Drei-Phasen-Brückenschaltung (**Fig. 2**), ergänzt durch einen zusätzlichen siebten Schalter, der als Bremssteller oder für eine Blindleistungsverbesserung (Phasenverbesserung) eingesetzt werden kann, wird das erfinderische Halbleiterbauelement erläutert. Dieses umfaßt eine Pegelwandlunung sowie die Treiber- und die Überwachungsfunktionen der 3 BOTTOM-Schalter der jeweiligen drei IGBT-Halbbrücken sowie des zusätzlichen siebten Schalters zusammen, so dass ein monolithisch integrierter Vierfach-Gatetreiber-IC (9) entsteht. Dieser Treiber-IC für 4 Halbleiterschalter liegt auf dem selben Potential, wie der primärseitige Ansteuer-IC (10) und der Kontroller (1). Ein gemeinsames Potential der BOTTOM- Schalter mit der Ansteuerung und dem Kontroller ist unter der Voraussetzung möglich, dass durch parasitäre Effekte verursachte Störspannungen im System relativ klein sind. Dies ist bei Leistungsteilen für kleinere und mittlere Leistungen (kleiner 150A, bis zu 1200V) und sehr kompakt aufgebauten Drei-Phasen-Brückenschaltungs-Modulen oft gegeben, bei denen die internen Induktivitäten und Widerstände konstruktiv sehr klein gehalten werden können. Die separaten Treiberstufen der 3 TOP-Schalter (11) der jeweiligen drei Halbbrücken können auf positiver Zwischenkreisspannung +DC (z.B. 300V ... 1200V) liegen. Sie müssen aus Isolationsgründen potentialmäßig getrennt werden (z.B. mittels Optokopplern). Das Ansteuersystem in Fig. 2 umfasst weiterhin einen Kontroller (1) und einen primärseitigen Ansteuer-IC (10).

Beispielhaft wird ein Halbleiterbauelement vorgestellt, das in einer CMOS-Hochspannungstechnologie realisiert worden ist, bei der die folgenden Funktionen für 4 IGBT-Gatetreiber implementiert sind:
- Pegelwandlung (mehrfach), Kurzimpulsunterdrückung, Signallaufzeitanpassung (12)
- Inbetriebnahmelogik (Power on Reset - POR) (22)
- Gatetreiber für normales Ein- und Ausschalten des IGBT
- Gatetreiber für langsames Ausschalten im Kurzschlussfall eines IGBT
- interne Betriebsspannungserzeugung (20) und -überwachung (21)
- Kurzschlußüberwachung des IGBT durch Kollektor-Emitter-Spannungsdetektierung (19)
- Fehlererfassung (1, 19) und -verarbeitung. (14, 15, 16)

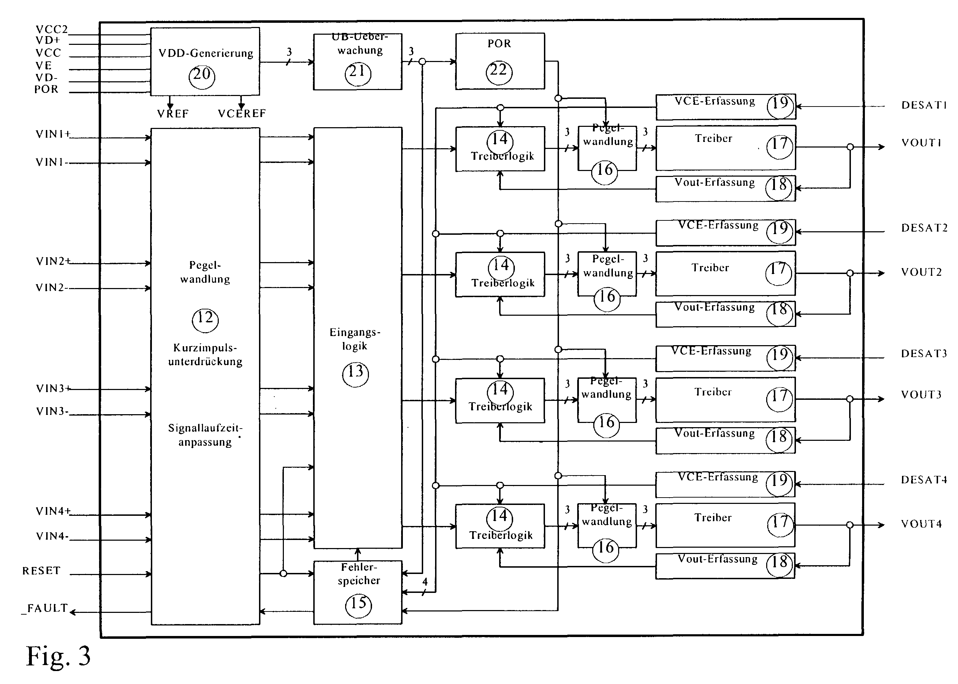

Die erfinderische Lösung des Vierfach-Gatetreiber-ICs wird auf der Grundlage eines detaillierten Blockschaltbildes in **Fig. 3** erläutert, welches die wichtigsten Schaltungsteile, Funktionen, Verbindungen sowie Ein- und Ausgänge des Halbleiterbauelements enthält. Die einzelnen Ein- und Ausgänge haben folgende Bedeutung:
- VIN1+ ... VIN4+: Steuereingänge für Signale vom Kontrollern zum Einschalten der 4 IGBT (3x BOT-IGBT der Halbbrücken sowie für den "siebten" Schalter); High aktiv
- VIN1- ... VIN4-: Steuereingänge (s.o.); Low aktiv
- VD+: Betriebsspannung zum Einschalten der IGBT, in der Regel 15V
- VD- : Betriebsspannung zum Abschalten der IGBT, variabel zwischen 0V ... -15V
- VCC1: 5V Betriebsspannung
- VE: Bezugspotential
- RESET: Eingang für Rücksetzimpuls vom Kontroller
- FAULT: Ausgang für Fehlermeldung
- VOUT1...VOUT4: Ausgänge zu den jeweiligen IGBT-Schaltern (Gate)
- DESAT1...DESAT4: Anschluß der jeweiligen separaten Hochspannungsdioden mit denen das Kollektor-Emitter-Potential direkt am Kollektor des jeweiligen IGBT's für eine Kurzschlußüberwachung abgegriffen wird.

Der Vierfach-Gatetreiber-IC ist in der Lage, sowohl positive als auch negative Schaltsignale vom Kontroller zu verarbeiten. Diese Signale werden in dem Schaltungsblock Eingangs-Pegelwandlung (12) auf internen Logikpegel umgesetzt. Signale < 170ns werden als Störsignale interpretiert und automatisch unterdrückt. Weiterhin wird die Signallaufzeit innerhalb des integrierten Gatetreibers auf die Signallaufzeit der Gatetreiber der TOP-Schalter (mit langsamen Optokopplern) angepasst.

Im Schaltungsblock Eingangslogik (13) werden die gültigen positiven und negativen Schaltsignale miteinander sowie mit dem RESET-Signal vom Kontroller (1), einem möglichen Fehlersignal im Fehlerspeicher (15) und dem Power On Reset (POR) (22) logisch verknüpft. Ein Fehlersignal wird dabei die Signalwege sperren, während nach einem RESET-Signal der Fehlerspeicher zurückgesetzt und der Signalweg wieder freigegeben wird.

Der Schaltungsblock Treiberlogik (14) beinhaltet jeweils folgende Schaltungsfunktionen:
- gegenseitige Verriegelung der p- und n-MOS-Gatetreiberstufen zum Ein- bzw. Ausschalten der IGBTs (Verriegelungszeit ca. 15ns),
- lokaler Fehlerspeicher für VCE-Fehler des jeweiligen IGBT-Schalters sowie Steuerung der "Sanft-Abschaltung" im Kurzschlussfall,
- Trennung der verschiedenen Ansteuersignale für Einschalten (p-MOSFET), Abschalten (n-MOSET) und Kurzschlußabschaltung (n-MOSFET mit reduziertem Stromvermögen),
- Rücksetzen des lokalen VCE-Fehlerspeichers nach "Sanft-Abschaltung".

Im Falle eines VCE-Fehlers wird der jeweilige IGBT sofort "sanft" abgeschaltet und ein Fehlersignal über den Fehlerspeicher (15) an den Mikroprozessor (1) gegeben (FAULT-Ausgang). Intern führt das Fehlersignal über den Fehlerspeicher (15) und die Eingangslogik (13) zum "harten" Abschalten der übrigen 3 BOTTOM-IGBTs. Die Abschaltsignale für das "harte" Abschalten der TOP-IGBTs werden vom primärseitigen Ansteuer-IC oder vom Kontroller aus dem FAULT- Signal generiert. Analog gilt diese Fehlerbehandlung auch, wenn ein VCE-Fehler an einem TOP-IGBT auftritt.

In dem Schaltungsblock Ausgangs-Pegelwandlung (16) werden die 5V-Ansteuersignale auf VD+-Pegel (meist 15V für Einschalten) bzw. auf VD- -Pegel (Spannungen zwischen 0V und -15V für das Abschalten) transformiert.

Die Treiber-Stufen (17) für das "harte" Einschalten der jeweiligen IGBTs (p-MOSFET) und das "harte" Ausschalten (n-MOSET) sind mehrstufig ausgelegt und haben ein Peakstromvermögen von max. 3A. Damit können z.B. 1200V-IGBT-Schalter bis 150A direkt angesteuert werden. Die zusätzliche n-MOSFET- Treiberstufe für das "sanfte" Abschalten im Kurzschlußfall hat nur ein Bruchteil (z.B. ein Zehntel) dieses Stromvermögens, wodurch der Abschaltvorgang langsam erfolgt und damit Probleme, wie z.B. Überspannungen, Schwingungen, dynamische Belastungen bis hin zur Zerstörung des IGBT, vermieden werden.

Mit der Schaltung VOUT- Erfassung (18) wird der Spannungsabfall am Ausgang VOUT während des "sanften" Abschaltens überwacht. Ist die Bedingung VOUT= (VD- +1V) erfüllt, so wird der "harte" Abschaltvorgang eingeleitet, um den weiteren Abschaltvorgang zu verkürzen, und der lokale VCE-Fehlerspeicher in der Treiberlogik (14) zurückgesetzt.

Das Kollektor-Potential am IGBT wird über eine diskrete Hochspannungsdiode (HV-Diode, siehe Fig. 2) direkt abgegriffen. Im Schaltungsblock VCE-Erfassung (19) wird die Kollektor-Emitter-Spannung am IGBT nach einer bestimmten Totzeit nach dem Einschalten detektiert. Im Falle eines normalen Einschaltens ist die Kollektorspannung nach der Totzeit auf die Sättigungsspannung des IGBT gesunken (z.B. VCE < 4V). Im Falle eines Kurzschlusses im Lastkreis entsättigt der IGBT, wodurch der Spannungsabfall über der Kollektor-Emitter-Strecke z.B. größer als 7V ist. Wird nun an der VCE-Erfassung ein Spannungsabfall größer 7V detektiert, so wird der jeweilige IGBT sofort "sanft" über die Treiberlogik (14) abgeschaltet. Über eine externe Beschaltung am Pin DESAT können bei Bedarf die VCEsat-Schwelle und die Totzeit an den jeweilig verwendeten IGBT und den Anwendungsfall angepaßt werden.

Während die Betriebsspannungen VCC1 (+5V) und VD+ (+15V) in der Regel fest liegen, kann VD- zwischen 0V und -15V je nach Anwendungsfall verändert werden. Aus diesem Grunde ist eine automatische interne Spannungsversorgung für die Logik (VDD-Generierung (20)) notwendig. Der Spannungswert wird dann auf VDD = VD- +5V geregelt.

Im Schaltungsblock UB-Überwachung werden VD+, VD- und VDD hinsichtlich Unterspannung überwacht. Treten Unterspannungen bei einer der Betriebsspannungen auf, so ist die sichere Betriebsweise des Leistungsteiles nicht mehr gewährleistet und die IGBTs erhalten über den Fehlerspeicher und die Eingangslogik ihre Abschaltimpulse am Treiber-Ausgang VOUT. Ein Rücksetzen des Fehlerspeichers ist nur bei Wegfall des Fehlers (FAULT) über einen RESET vom Kontroller möglich.

Die Schaltung POR (22) blockiert die Treiberschaltung während des Hochlaufens der Betriebsspannungen nach der Inbetriebnahme. Gleichzeitig werden die Ausgangstreiberstufen so gesetzt, daß kein Brückenkurzschluss auftreten kann (n-MOSFET: Ein; p-MOSFET: Aus). Werden die Unterspannungsschwellen aller 3 Betriebsspannungen überschritten, wird die Treiberschaltung freigegeben.

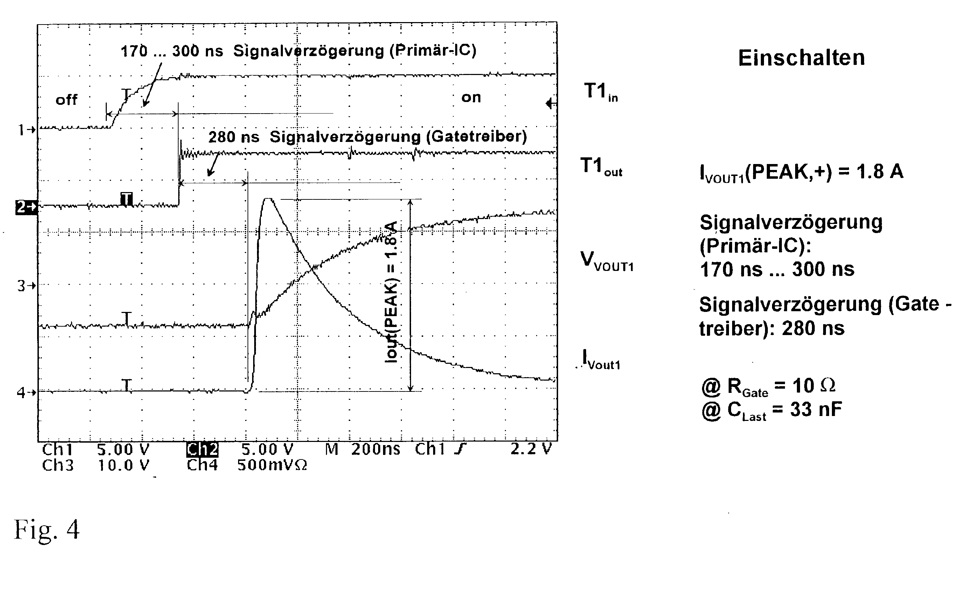

**Fig.4 - Fig.6** zeigen beispielhaft einige Messungen der realisierten Schaltungsfunktionen.

**Fig.4** zeigt die Treiberfähigkeit des Gatetreibers für den Einschaltvorgang. Die Signallaufzeit auf der Primärseite beträgt 170...300ns je nach Synchronisation des Eingangssignales auf den inneren Takt (siehe Kanal 1, T1in). Für die Sekundärseite beträgt die Laufzeit ca. 280ns (siehe Kanal 2, T1out). Auf Kanal 3 ist der gemessene Spannungsanstieg am Treiber-Ausgang Vout1 (-8V→+15V) und auf Kanal 4 der kapazitive Ladestrom (Iout PEAK=1,8A, für RG=10Ω, CL=33nF) dargestellt.

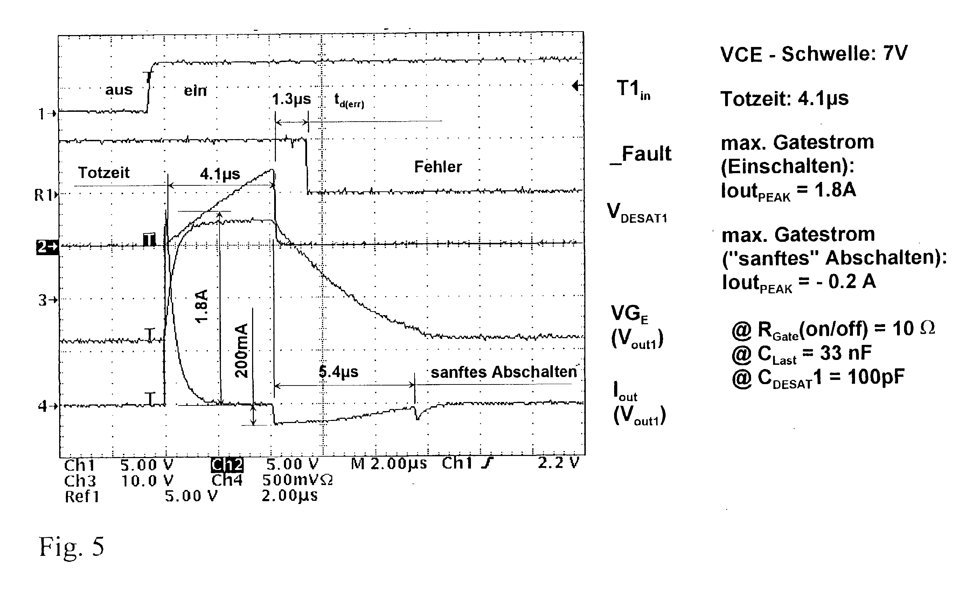

In **Fig.5** ist das gemessene Ein- und Ausschalten im Fehlerfall gezeigt. Die VCE-Erfassung erfolgt durch direktes Verbinden des IGBT-Kollektors mit dem jeweiligen Gate-Treiber über eine entsprechende Hochspannungsdiode. Nach einer gewissen Totzeit nach dem Einschalten (hier 4,1 µs, Kanal 3, DESAT1) sollte die Durchlaßspannung am IGBT unter einen Grenzwert (hier 7V) gefallen sein. Andernfalls liegt ein Kurzschluß am IGBT vor und er wird abgeschaltet (siehe Kanal 4 und 5 bei ca 8µs). Der entsprechende Ausschaltvorgang ist "sanft", d.h. der Gateentladestrom ist bedingt durch eine hochohmigere Treiberstufe klein (siehe Kanal 5, Iout PEAK=0,2A) und der Abschaltvorgang zieht sich über ca. 6µs. Dadurch werden hohe Spannungsspitzen beim Abschalten des Kurzschlußstromes verhindert. Die VCE-Schwelle und die Totzeit können am Treiber variiert werden.

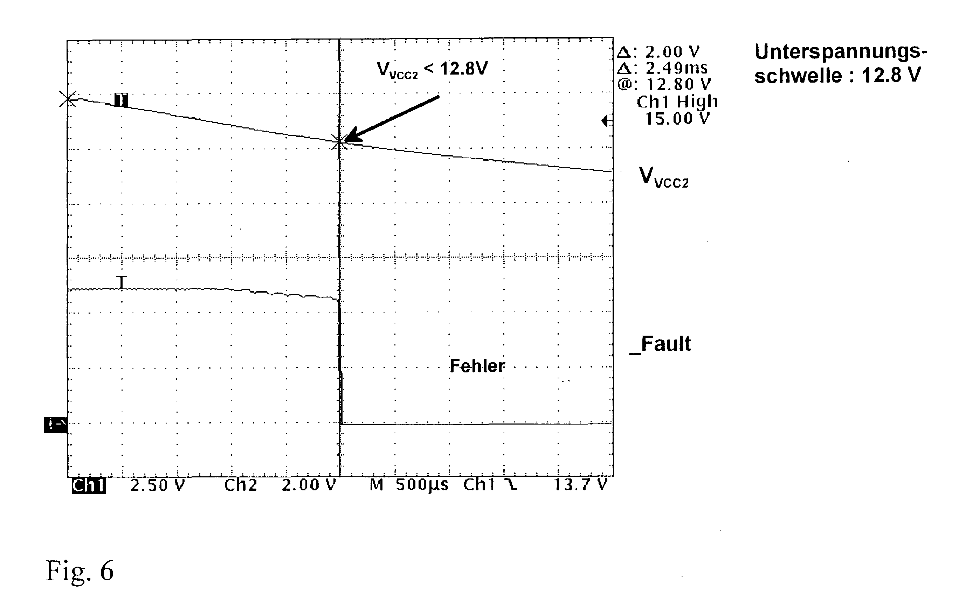

**Fig.6** zeigt beispielhaft die Funktion Betriebsspannungsüberwachung. Für die 15V-Betriebsspannung (VD+,VCC2) liegt die Fehler-Schwelle bei ca. 12,8V (über VE), für die intern generierte 5V-Spannung (VDD) bei ca. 3,0V (über VD-; nicht dargestellt).

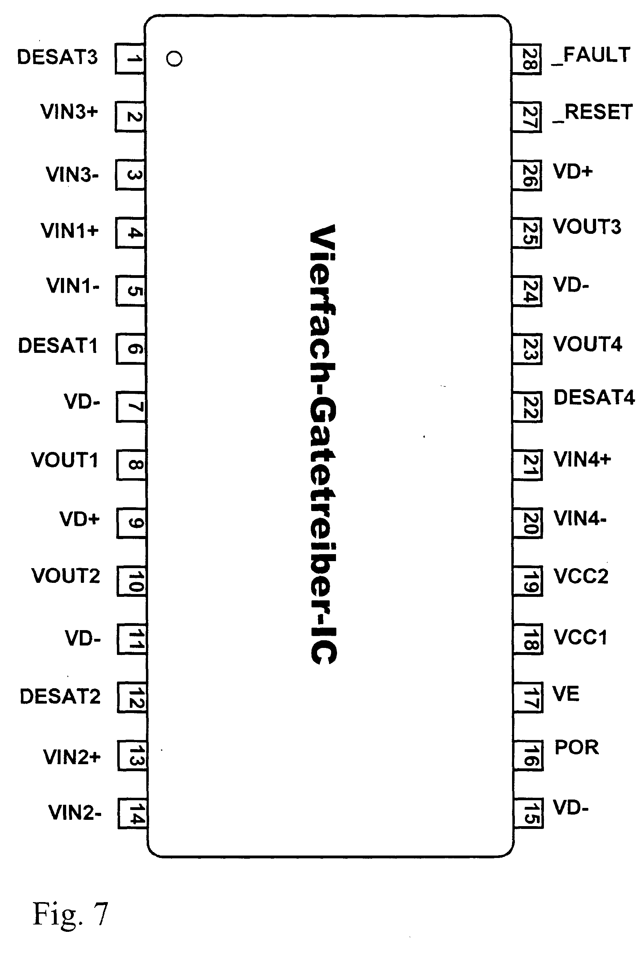

**Fig. 7** zeigt die Anschlußbelegung des Vierfach-Gatetreiber-ICs am Beispiel eines 28-poligen Small Outline Package (SOP 28). Die Tabelle 1 definiert dazu die Ein-und Ausgänge des ICs.

Die Vorteile des Ansteuer-IC gegenüber hybriden oder diskreten Lösungen bestehen in der hohen Integrationsdichte verschiedener Digital-, Analog- und Treiberfunktionen, die zu einer Reduzierung der Anzahl der diskreten Bauelemente und damit zu einer Verringerung der Ausfallrate des Systems und niedrigeren Kosten führen. Ein weitere wesentlicher Gesichtspunkt ist die Verbesserung der Schaltungseigenschaften durch die monolithische Integration. Die integrierte Schaltung besitzt ein geringere Störspannungsempfindlichkeit und Temperaturdrift im Vergleich zu diskret aufgebauten Schaltungen.

### Bezeichnungsliste

- 1: Kontroller
- 2: Steuerschaltung (Primärseite)
- 3: Potentialtrennung zwischen Primär- und Sekundärseite
- 4: Treiberschaltung
- 5: Spannungszwischenkreis
- 6: Leistungsschalter
- 7: Verbraucher
- 8: Sensoren mit Auswerteschaltung
- 9: Vierfach-Gatetreiber-IC
- 10: Ansteuer-IC
- 11: Gatetreiber
- 12: Logikeinheit Pegelwandlung, Kurzimpulsunterdrückung, Signallaufzeitanpassung
- 13: Eingangslogik
- 14: Treiberlogik
- 15: Fehlerspeicher
- 16: Pegelwandlung
- 17: Treiber-stufe
- 18: VOUT-Erfassung
- 19: VCE-Erfassung
- 20: VDD-Generierung
- 21: Überspannungsüberwachung
- 22: Inbetriebnahmelogik - POR (Power on Reset)

**Tabelle 1:**

| **PIN-Belegung SOP 28 Gehäuse (Fig. 7)** | | |
|---|---|---|
| **Anschluss** | **Symbol** | **Beschreibung** |
| 1 | DESAT3 | Anschluß Hochspannungsdiode für VCE -Überwachung IGBT3 |
| 2 | VIN3+ | Steuereingang IGBT3, High aktiv |
| 3 | VIN3- | Steuereingang IGBT3, Low aktiv |
| 4 | VIN1+ | Steuereingang IGBT1, High aktiv |
| 5 | VIN1- | Steuereingang IGBT1, Low aktiv |
| 6 | DESAT1 | Anschluß Hochspannungsdiode für VCE -Überwachung IGBT1 |
| 7 | VD- | Betriebsspann. zum Abschalten der IGBT (variabel 0V...-15V) |
| 8 | VOUT1 | Ausgang zum Gate IGBT1 |
| 9 | VD+ | Betriebsspannung zum Einschalten der IGBT (+15V) |
| 10 | VOUT2 | Ausgang zum Gate IGBT2 |
| 11 | VD- | Betriebsspann. zum Abschalten der IGBT (variabel 0V...-15V) |
| 12 | DESAT2 | Anschluß Hochspannungsdiode für VCE-Überwachung IGBT2 |
| 13 | VIN2+ | Steuereingang IGBT2, High aktiv |
| 14 | VIN2- | Steuereingang IGBT2, Low aktiv |
| 15 | VD- | Betriebsspann. zum Abschalten der IGBT (variabel 0V...-15V) |
| 16 | POR | Power On Reset |
| 17 | VE | Bezugspotential |
| 18 | VCC1 | Betriebsspannung 5V |
| 19 | VCC2 | Betriebsspannung 15V |
| 20 | VIN4- | Steuereingang IGBT4, Low aktiv |
| 21 | VIN4+ | Steuereingang IGBT4, High aktiv |
| 22 | DESAT4 | Anschluß Hochspannungsdiode für VCE -Überwachung IGBT4 |
| 23 | VOUT4 | Ausgang zum Gate IGBT4 |
| 24 | VD- | Betriebsspann. zum Abschalten der IGBT (variabel 0V...-15V) |
| 25 | VOUT3 | Ausgang zum Gate IGB 3 |
| 26 | VD+ | Betriebsspannung zum Einschalten der IGBT (+15V) |
| 27 | RESET | Eingang für Rücksetzimpuls vom Kontroller |
| 28 | FAULT | Ausgang für Fehlermeldung |

## Patentansprüche

1. Halbleiterbauelement zur Ansteuerung von Leistungshalbleiterschaltern, vorzugsweise MOSFET oder IGBT, in Umrichtern der Leistungsklasse
**dadurch gekennzeichnet, dass**
die Funktionen
• Signalaufbereitung (12) der primärseitigen Eingangssignale,
• Inbetriebnahmelogik (22),
• Kurzschlussüberwachung (19),
• Gatetreiber (14, 16, 17, 18) zur Ansteuerung im Normalbetrieb wie auch im Kurzschlussfall,
• interne Betriebsspannungserzeugung (20) und -überwachung (21),
• Fehlererfassung und -verarbeitung (13, 14, 15, 19) für mehrere Leistungshalbleiterschalter monolithisch integriert sind.

2. Halbleiterbauelement nach Anspruch 1,
**dadurch gekennzeichnet, dass**
dessen vier integrierten identisch aufgebauten Gatetreiber (14, 16, 17, 18, 19) in einer Drei-Phasen-Brückenschaltung die drei BOTTOM-Schalter sowie einen zusätzlichen Schalter, der als Bremssteller oder zur Blindleistungsverbesserung dient, ansteuern und überwachen.

3. Halbleiterbauelement nach Anspruch 1,
**dadurch gekennzeichnet, dass**
die Signalaufbereitung (12) eine Pegelwandlung der Eingangssignale auf den internen Signalpegel der integrierten Schaltung durchführt, eine Kurzimpulsunterdrückung für Störsignale beinhaltet und eine Signallaufzeitanpassung der primärseitigen Ansteuersignale für alle anzusteuernden Leistungshalbleiterschalter durchführt.

4. Halbleiterbauelement nach Anspruch 1,
**dadurch gekennzeichnet, dass**
die interne Betriebsspannungsüberwachung (21) eine Unterspannungsüberwachung der intern erzeugten sowie der extern anliegenden Betriebsspannungen integriert, die im Fehlerfall zur geregelten Abschaltung aller Leistungsschalter der Drei-Phasen-Brückenschaltung führt.

5. Halbleiterbauelement nach Anspruch 1,
**dadurch gekennzeichnet, dass**
in der Fehlererfassung (13, 14, 15) eine Kurzschlussüberwachung (19) der Halbleiterschalter durch die Überwachung der Kollektor-Emitter-Spannung (VCE) der Leistungshalbleiterschalter vorgenommen wird.

6. Halbleiterbauelement nach Anspruch 1,
**dadurch gekennzeichnet, dass**
die interne Betriebsspannungserzeugung (20) eine konstante Spannung erzeugt, deren Bezugspotential die extern anliegende variable Betriebsspannung zum Abschalten der Leistungsschalter darstellt.

7. Halbleiterbauelement nach Anspruch 1,
**dadurch gekennzeichnet, dass**
die Inbetriebnahmelogik (22) bei der Inbetriebnahme des Umrichters einen Brückenkurzschluss sicher verhindert indem erst zum Zeitpunkt des Erreichen aller Betriebsspannungsschwellen und zu diesem Zeitpunkt durchgeführtem Rücksetzen der internen Fehlerspeicher (15, 16) die Treiberschaltungen (14, 16, 17) freigeschaltet werden.

8. Halbleiterbauelement nach Anspruch 1,
**dadurch gekennzeichnet, dass**
die Fehlererfassung (13, 14, 15) bei der Registrierung einer Fehlfunktion eines durch das Halbleiterbauelement angesteuerten Leistungshalbleiterschalters ein in der zum jeweiligen Schalter gehörigen Treiberlogik integrierter Fehlerspeicher gesetzt wird wodurch dieser Leistungshalbleiterschalter sanft abgeschaltet wird, ein globaler Fehlerspeicher (15) gesetzt wird wodurch alle anderen durch das Halbleiterbauelement angesteuerten Leistungshalbleiterschalter ebenfalls abgeschaltet werden weiterhin wird die Fehlerinformation an die primärseitigen Ansteuerschaltungen (1, 10) zur Abschaltung der weiteren Leistungshalbleiterschalter der Drei-Phasen-Brückenschaltung weitergegeben.

9. Halbleiterbauelement nach Anspruch 1,
**dadurch gekennzeichnet, dass**
der Gatetreiber (16) aus einem p-MOSFET für das "harte" Einschalten, einem n-MOSFET für das "harte" Abschalten und einem n-MOSFET für das "sanfte" Abschalten im Kurzschlussfall, der nur einen Bruchteil des Stromvermögens verglichen mit dem Transistor (n-MOSFET) für das "harte" Abschalten besitzt, bestehen.

10. Halbleiterbauelement nach Anspruch 8,
**dadurch gekennzeichnet, dass**
die Gatespannung während der Sanftabschaltung am Gate des Leistungsschalters überwacht wird und bei unterschreiten eines definierten Schwellenwerts der weitere Abschaltvorgang durch ein "hartes" Abschalten verkürzt wird.

11. Halbleiterbauelement nach Anspruch 1,
**dadurch gekennzeichnet, dass**
nach einer Fehlfunktion und einem primärseitigen Wiedereinschaltsignal (Reset) alle Fehlerspeicher gelöscht und ein geregeltes Wiederanlaufen der Treiberschaltung ausgelöst wird, sofern kein Fehler mehr aktuell vorliegt.
